(19) Europäisches Patentamt
European Patent Office
Office européen des brevets

(11) EP 2 705 070 B1

(12) FASCICULE DE BREVET EUROPEEN

(45) Date de publication et mention de la délivrance du brevet:
**28.02.2018 Bulletin 2018/09**

(21) Numéro de dépôt: **12725054.6**

(22) Date de dépôt: **26.04.2012**

(51) Int Cl.:
***C08G 61/12*** (2006.01) ***C08G 81/02*** (2006.01)
***H01L 51/00*** (2006.01) ***B82Y 30/00*** (2011.01)
***B82Y 10/00*** (2011.01) ***C08F 290/06*** (2006.01)
***C08L 87/00*** (2006.01)

(86) Numéro de dépôt international:
**PCT/FR2012/050922**

(87) Numéro de publication internationale:
**WO 2012/150404 (08.11.2012 Gazette 2012/45)**

# (54) COMPOSITION POUR COUCHE ACTIVE OU ELECTRODE DE CELLULES PHOTOVOLTAÏQUES

ZUSAMMENSETZUNG FÜR EINE AKTIVE SCHICHT ODER DER ELEKTRODE EINER PV-ZELLE

COMPOSITION FOR AN ACTIVE LAYER OR ELECTRODE OF PHOTOVOLTAIC CELLS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.05.2011 FR 1153720**

(43) Date de publication de la demande:
**12.03.2014 Bulletin 2014/11**

(73) Titulaires:
- **Université de Bordeaux**
  **33000 Bordeaux (FR)**
- **Arkema France**
  **92700 Colombes (FR)**
- **Centre National de la Recherche Scientifique**
  **75794 Paris Cedex 16 (FR)**
- **Institut Polytechnique de Bordeaux**
  **33402 Talence Cedex (FR)**

(72) Inventeurs:
- **MOUGNIER, Sébastien-Jun**
  **75009 Paris (FR)**
- **BROCHON, Cyril**
  **F-33700 Merignac (FR)**
- **HADZIIOANNOU, Georges**
  **F-33850 Leognan (FR)**
- **CLOUTET, Eric**
  **F-33880 Saint-caprais De Bordeaux (FR)**
- **NAVARRO, Christophe**
  **F-64990 Lahonce (FR)**

(74) Mandataire: **Gorintin, Sarah et al**
**ARKEMA France**
**Département Propriété Industrielle**
**420, rue d'Estienne d'Orves**
**92705 Colombes Cedex (FR)**

(56) Documents cités:
**WO-A2-2006/096550**

- **ERTUGRUL SAHMETLIOGLU ET AL: "Synthesis and characterization of conducting copolymers of poly(vinyl alcohol) with thiophene side-groups and pyrrole", POLYMER INTERNATIONAL, vol. 53, no. 12, 1 janvier 2004 (2004-01-01), pages 2138-2144, XP055012718, ISSN: 0959-8103, DOI: 10.1002/pi.1644**
- **GREGORY L. BAKER ET AL: "Synthesis of polyacetylene block/graft copolymers", MACROMOLECULES, vol. 17, no. 12, 1 décembre 1984 (1984-12-01), pages 2619-2626, XP055012721, ISSN: 0024-9297, DOI: 10.1021/ma00142a028**
- **TANAKA ET AL: "Alternate network film of thiol group-terminated polythiophene and gold nanoparticle", POLYMER, ELSEVIER SCIENCE PUBLISHERS B.V, GB, vol. 48, no. 20, 14 septembre 2007 (2007-09-14), pages 5884-5888, XP022243756, ISSN: 0032-3861, DOI: 10.1016/J.POLYMER.2007.08.016**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 2 705 070 B1

- **KUMARANAND PALANIAPPAN ET AL: "Poly(3-hexylthiophene)-CdSe Quantum Dot Bulk Heterojunction Solar Cells: Influence of the Functional End-Group of the Polymer", MACROMOLECULES, vol. 42, no. 12, 23 juin 2009 (2009-06-23) , pages 3845-3848, XP055012731, ISSN: 0024-9297, DOI: 10.1021/ma9006285**
- **SÉBASTIEN-JUN MOUGNIER ET AL: "Design of Well-Defined Monofunctionalized Poly(3-hexylthiophene)s: Toward the Synthesis of Semiconducting Graft Copolymers", MACROMOLECULAR RAPID COMMUNICATIONS, vol. 33, no. 8, 23 avril 2012 (2012-04-23) , pages 703-709, XP55032341, ISSN: 1022-1336, DOI: 10.1002/marc.201100703**

## Description

### Domaine de l'invention

L'invention a pour objet une composition pour des cellules photovoltaïques organiques de modules photovoltaïques présentant des propriétés optimums pour cette application ainsi que cette même composition, très légèrement différente (un composant en moins), pour des électrodes. La présente invention concerne également l'utilisation d'une telle composition dans des cellules photovoltaïques organiques d'un module photovoltaïque et un module photovoltaïque comprenant de telles cellules photovoltaïques ainsi que son utilisation dans des électrodes.

Dans la suite, la composition selon l'invention est présentée au regard des problèmes techniques liés au domaine des cellules photovoltaïques mais il est apparu à la demanderesse que les avantages particulièrement significatifs et nombreux de cette composition rendaient cette dernière susceptible d'être envisagée comme solution technique pour des problématiques existants dans d'autres domaines, au regard en particulier de sa résolution d'au moins un problème technique (dispersion des nanotubes de carbone ou de graphène utilisables pour la fabrication d'électrodes).

Le réchauffement climatique, lié aux gaz à effet de serre dégagés par les énergies fossiles, a mené au développement de solutions énergétiques alternatives qui n'émettent pas de tels gaz lors de leur fonctionnement, comme par exemple les modules photovoltaïques. Un module photovoltaïque comprend une « pile photovoltaïque », cette pile étant capable de transformer l'énergie lumineuse en électricité.

Il existe de nombreux types de structures de panneaux photovoltaïques.

A l'heure actuelle, il est utilisé majoritairement des panneaux photovoltaïques dits inorganiques, c'est-à-dire fonctionnant avec une plaque de semi-conducteurs, généralement du silicium, formant une pile photovoltaïque pour piéger les photons. A titre d'exemple, une pile photovoltaïque comprend classiquement une pluralité de cellules, chaque cellule contenant un capteur photovoltaïque en contact avec des collecteurs d'électrons placés au-dessus (collecteurs supérieurs) et au-dessous (collecteurs inférieurs) du capteur photovoltaïque. Lorsque la pile photovoltaïque est placée sous une source lumineuse, elle délivre un courant électrique continu, qui peut être récupéré aux bornes de la pile.

Outre la pile photovoltaïque inorganique, on connaît également des cellules photovoltaïques de type organique, c'est-à-dire que les cellules photovoltaïques sont composées de polymères. A l'instar des piles photovoltaïques inorganiques, ces cellules photovoltaïques organiques absorbent les photons, des paires électron-trou liées (excitons) étant générées et contribuant au photocourant.

La pile photovoltaïque organique est moins coûteuse, recyclable et permet d'étendre l'offre à des produits souples ou des conformations diverses (par exemple tuiles de bâtiments), donnant accès à des marchés inaccessibles aux technologies classiques, notamment par leur intégration à des systèmes multifonctionnels. Néanmoins, cette solution souffre jusqu'à présent d'un très faible niveau efficacité globale puisque le rendement de telles cellules photovoltaïques reste inférieur à 5%. Par ailleurs, à l'heure actuelle, la durée de vie des cellules photovoltaïques est très limitée.

### Etat de l'art

La performance et la durée de vie médiocres des cellules photovoltaïques organiques sont directement liées à un certain nombre de paramètres physico-chimiques qui posent à l'heure actuelle des difficultés.

Une cellule photovoltaïque organique est composée d'un matériau donneur d'électrons et d'un matériau accepteur d'électrons. Un premier problème technique se pose au regard du contrôle de la morphologie de mélange des matériaux donneur et accepteur d'électrons.

A l'heure actuelle, pour palier cette difficulté, la stratégie consiste à jouer sur les conditions de recuit pour obtenir la morphologie désirée mais il est également connu, par exemple du document US 2009/0229667, d'ajouter des additifs, tels que des dithiols ou des halogénures d'alcanes, qui vont jouer le rôle de plastifiant susceptibles de migrer, mais qui ne stabilisent pas les morphologies. Néanmoins, si on souhaite obtenir des structures stables, il faut introduire des tensioactifs. On sait notamment qu'il existe des copolymères diblocs ou triblocs possédant une séquence conjuguée ou des copolymères diblocs mais ne comportant aucune séquence conjuguée. On connaît ainsi le document US 2008/0017244 mais les copolymères à blocs jouent ici le rôle de transporteur de charges (donneur/accepteur) ainsi que de surfactant mais ne résolvent pas le susdit premier problème technique.

Toutes ces solutions existantes ne sont pas très satisfaisantes concernant le contrôle ou la stabilisation de la morphologie de mélange des matériaux donneur et accepteur d'électrons.

Un second problème technique réside dans le contrôle et la stabilisation de la dispersion de la matière que ce soit au niveau de la couche active ou de l'électrode (polymère semi-conducteur, graphène, nanotubes de carbones etc...) dans le milieu liquide pour l'élaboration d'encre. En effet, l'élaboration des cellules photovoltaïques organiques se fait essentiellement par voie humide, c'est-à-dire en utilisant des encres. En ce qui concerne les électrodes, ceci est également applicable à d'autres types de dispositifs, tels que les diodes électroluminescentes organiques (OLEDs).

Les solutions connues consistent à l'heure actuelle à ajouter des additifs tels qu'un tensioactif (ionique ou

neutre) ou des polymères hydrophiles comme le poly(alcool vinylique). Ces additifs ne donnent pas pleinement satisfaction, car il est notamment connu de l'homme du métier qu'ils ont tendance à provoquer une coagulation des charges présentes.

Un dernier problème réside dans le contrôle et la stabilisation des interfaces organique/inorganique dans une cellule photovoltaïque organique disposant classiquement d'au moins une électrode métallique.

Les solutions utilisées à l'heure actuelle consistent en l'ajout d'une couche intermédiaire fixée/collée contre ladite électrode telle qu'un autre polymère semi-conducteur ou une monocouche auto-assemblée de petites molécules (SAM). A nouveau, ces solutions, bien que permettant de résoudre partiellement le problème, ne sont pas totalement satisfaisantes.

On connait également les documents suivants :

- le document WO 2006/096550 qui décrit des polymères greffés ayant un tronc polyacrylate et des greffons poly (alkyl thiophène) ;

- l'article intitulé « Synthesis and characterization of conducting copolymers of poly(vinyl alcohol) with thiophene side-groups and pyrrole", de Ertugrul Sahmetlioglu et Al., Polymer International, publié le 1 janvier 2004, qui décrit des polymers ayant un tronc linéaire de poly (vinyl alcool) et des greffons constitués de polymère conjudué (polythiophène) ;

- l'article intitulé « Synthesis of polyacetylene block/graft copolymers », de Gregory L. Baker et Al., Macromolecules, publié le 1er décembre 1984, qui décrit des polymères ayant un tronc polyisoprène et des greffons polyacétylène.

## Brève description de l'invention

La présente invention entend remédier aux problèmes des cellules photovoltaïques organiques de modules photovoltaïques et des électrodes de l'art antérieur en proposant une composition, pour couche active et/ou électrode d'une cellule photovoltaïque organique, comprenant une association d'un copolymère greffé d'un type particulier et d'une ou plusieurs substances spécifiques créant une synergie avec ledit copolymère.

Il a été constaté par la demanderesse, après diverses expériences et manipulations, qu'une structure particulière pouvait seule présenter des résultats optimums permettant :

- d'améliorer la compatibilisation d'un mélange entre un matériau donneur et un matériau accepteur d'électrons dans une cellule solaire/photovoltaïque organique que ce soit en terme de performance et en terme de stabilité ;
- d'améliorer la qualité des encres (leurs stabilités notamment dans le temps), notamment de dispersion des nanotubes de carbone et de graphène utilisable pour la fabrication d'électrodes ;
- d'éviter les problème physico-chimique d'interface métal/matériau organique.

De manière générale, ces problèmes techniques étant résolus, les cellules photovoltaïques organiques ou une électrode incorporant la composition selon l'invention présentent un rendement énergétique bien supérieur à celles de l'art antérieur.

Ainsi, la présente invention concerne une composition comprenant un copolymère greffé constitué :

- d'un tronc linéaire comprenant au moins un polymère vinylique non aromatique ou une polyoléfine insaturée, et
- au moins deux greffons, rattachés au dit tronc par une liaison chimique, chacun constitué d'un polymère conjugué,

caractérisée en ce que ladite composition comprend en outre :

- des fullerènes et un polymère conjugué, ou
- des nanotubes de carbone et/ou du graphène.

Ainsi, la composition selon l'invention présente une alternative.

Dans le cas où cette composition est destinée à être utilisée pour constituer tout ou partie de cellules photovoltaïques, le susdit copolymère sera associé à des fullerènes et un polymère conjugué. Ces deux derniers éléments sont nécessaires pour répondre aux caractéristiques propres au domaine photovoltaïques, dont notamment la transparence de la composition et sa résistivité thermique et mécanique.

On notera par ailleurs que l'on entend par le terme « fullerènes » une molécule composée exclusivement de carbones pouvant prendre une forme géométrique rappelant celle d'une sphère, d'un ellipsoïde, d'un tube (appelé nanotube) ou d'un anneau.

Dans le cas où cette composition est destinée à être utilisée en tant qu'électrode, le polymère conjugué n'est plus nécessaire, les nanotubes de carbone et/ou le graphène étant recherché pour leurs bonnes conductivités électriques sans nécessiter de propriété de transparence.

Dans les deux alternatives, il a été démontré, après de multiples expérimentations, que le susdit copolymère permet d'obtenir, avec lesdits fullerènes et ledit polymère conjugué ou avec lesdits nanotubes de carbones et/ou de graphènes, des résultats très intéressants, en particulier ceux susmentionnés.

D'autres caractéristiques avantageuses de l'invention sont précisées dans la suite :

- avantageusement, les deux greffons ont la même masse molaire ;
- de préférence, les susdits greffons consistent en du poly-(3-hexylthiophène) ;
- avantageusement, le tronc linéaire, de nature polyoléfine insaturée, consiste en un polydiène, de préférence un polyisoprène ou un polybutadiène, de façon préférentielle un polyisoprène ;
- selon une solution alternative, le tronc linéaire, de nature polyoléfine insaturée, consiste en un polymère acrylique ou polyacrylate ;
- ledit tronc pourra avantageusement consister en un polyacrylate d'alkyle, de préférence du poly(acrylate de n-butyle) ;
- de préférence, le tronc possède des fonctions hydroxyles de sorte à lui conférer des propriétés amphiphiles ;
- selon une possibilité, le tronc linéaire, de nature polyoléfine insaturée, consiste en du poly(alcool vinylique).

L'invention se rapporte à l'utilisation de la composition décrite précédemment dans les cellules photovoltaïques organiques d'un module photovoltaïque.

En outre, l'invention se rapporte aussi à un module photovoltaïque présentant au moins une couche formant un encapsulant comportant une pile photovoltaïque, consistant en une pluralité de cellules photovoltaïques organiques apte à générer de l'énergie électrique et une couche formant un « backsheet » ou panneau arrière, ladite pile photovoltaïque comprenant une composition telle que décrit ci-dessus lorsqu'elle comporte des fullerènes et un polymère conjugué.

Enfin, il est décrit des modes de synthèses originaux de la composition selon l'invention ou des éléments/matériaux intermédiaires nécessaires à sa fabrication.

Ainsi, il est décrit un procédé de synthèse du polymère conjugué, de préférence du poly(3-hexylthiophène), terminé ω-thiol, comprenant les étapes successives de :

- traitement d'une quantité Q1 de P3HT terminé ω-allyle dans un contenant préalablement mis sous atmosphère inerte, par exemple par une pluralité de cycles de vide/diazote ;
- ajout d'une quantité Q2 de solvant aromatique apolaire, de préférence le toluène, le rapport Q1/Q2 étant compris entre 15 et 50 ;
- ajout d'une quantité Q3 d'un alcane dithiol, de préférence le 1,3-propanedithiol, Q3 étant inférieure à Q2 ;
- ajout d'une quantité Q4 d'un générateur de radicaux du type peroxydique ou diazoïque, tel que de préférence l'azobisisobutyronitrile (AIBN), Q4 étant inférieure à Q2;
- maintient le mélange à une température comprise entre 0°C et 200°C, suivant les systèmes générateurs de radicaux utilisés, et typiquement de 40°C et 130°C pendant un temps minimum d'une heure dans le cas préférentiel d'utilisation de l'AIBN ;
- ajout d'une quantité éventuelle Q5 de générateur de radicaux pouvant être similaire ou non à celui utilisé en Q4, tel que l'azobisisobutyronitrile (AIBN), Q5 étant de préférence égale à Q4 mais pouvant être compris entre 0 et 10 Q4 ;

maintient éventuel, dans le cas ou Q5 est non nul du mélange à une température comprise entre 0°C et 200°C, suivant les systèmes générateurs de radicaux utilisés, et typiquement de 40°C et 130°C pendant un temps minimum d'une heure dans le cas préférentiel d'utilisation de l'AIBN.

Il est également décrit un procédé de synthèse de copolymère greffé Polyoléfine-g-P3HT, de préférence PI-g-P3HT comprenant les étapes successives de :

- traitement d'une quantité Q1 de P3HT terminé ω-thiol dans un contenant mis sous atmosphère inerte, par exemple par une pluralité de cycles de vide/diazote ;
- ajout d'une quantité Q2 de solvant aromatique apolaire, de préférence le toluène, le rapport Q1/Q2 étant compris entre 5 et 30 ;
- maintient du mélange à plus de 25°C et de préférence à plus de 40°C pendant au moins 30 minutes ;
- ajout d'une quantité Q3 de polyoléfine insaturée, telle que le polybutadiène ou de préférence le poly(isoprène), Q3 étant compris entre Q1 et Q2 ;
- ajout d'une quantité Q4 d'un générateur de radicaux du type peroxydique ou diazoïque, tel que de préférence

l'azobisisobutyronitrile (AIBN), Q4 étant inférieure à Q2;

- maintient le mélange à une température comprise entre 0°C et 200°C, suivant les systèmes générateurs de radicaux utilisés, et typiquement de 40°C et 130°C pendant un temps minimum d'une heure dans le cas préférentiel d'utilisation de l'AIBN ;
- ajout d'une quantité éventuelle Q5 de générateur de radicaux pouvant être similaire ou non à celui utilisé en Q4, tel que l'azobisisobutyronitrile (AIBN), Q5 étant de préférence égale à Q4 mais pouvant être compris entre 0 et 10 Q4 ;

maintient éventuel, dans le cas ou Q5 est non nul du mélange à une température comprise entre 0°C et 200°C, suivant les systèmes générateurs de radicaux utilisés, et typiquement de 40°C et 130°C pendant un temps minimum d'une heure dans le cas préférentiel d'utilisation de l'AIBN.

Il est également décrit un procédé de synthèse de copolymère greffé poly(3-hexylthiophène) terminé ω-acrylate, comprenant les étapes successives de :

- traitement d'une quantité Q1 de P3HT terminé ω-hydroxyle dans un contenant préalablement mis sous atmosphère inerte, par exemple par une pluralité de cycles de vide-diazote ;
- ajout d'une quantité Q2 de solvant polaire, de préférence le tetrahydrofurane, le rapport Q1/Q2 étant compris entre 2 et 10 ;
- ajout d'une quantité Q3 d'une base, de préférence une amine tertiaire, de façon préférentielle la triéthylamine, Q3 étant inférieure à Q2 ;

ajout d'un chlorure d'acide, de préférence un chlorure de (méth)acryloyle, de façon préférentielle, le chlorure d'acryloyle.

De façon avantageuse, tous les procédés visés ci-dessus comportent une étape finale d'isolement du produit par les techniques connus de l'homme du métier, comme par exemple par évaporation de solvant ou de préférence par précipitation dans du méthanol froid puis filtration/séchage du produit.

## Description des Figures annexées

La description qui va suivre est donnée uniquement à titre illustratif et non limitatif en référence aux figures annexées, dans lesquelles :

- la Figure 1 présente l'aspect général du copolymère greffé selon l'invention ;
- la Figure 2 est une photographie d'une dispersion de MWNTC dans de l'eau en présence de PVA-g-P3HT.

## Description détaillée de l'invention

La composition selon l'invention comprend, dans sa définition générale, un copolymère greffé constitué :

- d'un tronc linéaire 1 comprenant au moins un polymère vinylique non aromatique ou une polyoléfine insaturée, et

- au moins deux greffons 2, rattachés au dit tronc par une liaison chimique, chacun constitué d'un polymère conjugué.

S'agissant du tronc linéaire 1 du copolymère greffé, c'est un polymère comprenant comme monomère une α-oléfine.

On préfère les α-oléfines ayant de 2 à 30 atomes de carbone.

A titre d'α-oléfine, on peut citer l'éthylène, le propylène, 1-butène, 1-pentène, 3-méthyl-1-butène, 1-hexène, 4-méthyl-1-pentène, 3-méthyl-1-pentène, 1-octène, 1-décène, 1-dodécène, 1-tétradécène, 1-hexadécène, 1-octadécène, 1-eicocène, 1-dococène, 1-tétracocène, 1-hexacocène, 1-octacocène, et 1-triacontène.

Cette polyoléfine peut-être un homopolymère lorsqu'une seule α-oléfine est polymérisée dans la chaîne polymère. On peut citer comme exemples le polyéthylène (PE) ou le polypropylène (PP). Cette polyoléfine peut aussi être obtenue par hydrogénation d'un polydiène tel que le polyisoprène ou polybutadiène.

Cette polyoléfine peut aussi être un copolymère lorsqu'au moins deux comonomères sont copolymérisés dans la chaîne polymère, l'un des deux comonomères dit le « premier comonomère » étant une α-oléfine et l'autre comonomère, dit « deuxième comonomère », est un monomère capable de polymériser avec le premier monomère.

A titre de deuxième comonomère, on peut citer :

- une des α-oléfines déjà citées, celle-ci étant différente du premier comonomère α-oléfine,

- les diènes tels que par exemple le 1,4-hexadiène, l'éthylidène norbornène, le butadiène, l'isoprène.

- les esters d'acides carboxyliques insaturés tels que par exemple les acrylates d'alkyle ou les méthacrylates d'alkyle regroupés sous le terme (méth)acrylates d'alkyles. Les chaînes alkyles de ces (méth)acrylates peuvent avoir jusqu'à 30 atomes de carbone. On peut citer comme chaînes alkyles le méthyle, l'éthyle, le propyl, n-butyl, sec-butyl, Isobutyl, tert-butyl, pentyl, hexyl, heptyl, octyl, 2-ethylhexyl, nonyl, decyl, undecyl, dodecyl, tridecyl, tetradecyl, pentadecyl, hexadecyl, heptadecyl, octadecyl, nonadecyl, eicosyl, hencosyl, docosyl, tricosyl, tetracosyl, pentacosyl, hexacosyl, heptacosyl, octacosyl, nonacosyl. On préfère les (méth)acrylates de méthyle, éthyle et butyle comme esters d'acide carboxylique insaturés.

- les esters vinyliques d'acide carboxyliques. A titre d'exemples d'esters vinyliques d'acide carboxylique, on peut citer l'acétate de vinyle, le versatate de vinyle, le propionate de vinyle, le butyrate de vinyle, ou le maléate de vinyle. On préfère l'acétate de vinyle comme ester vinylique d'acide carboxylique.

On ne sortirait pas du cadre de l'invention si différents « deuxièmes comonomères » étaient copolymérisés dans le tronc polyoléfine.

De manière générale, le tronc linéaire 1 pourra consister en une molécule telle que décrite ci-après :

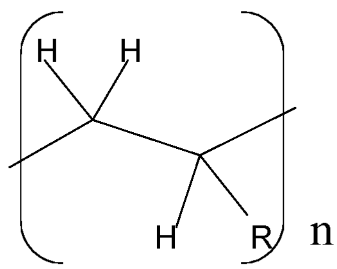

où R n'est pas une molécule aromatique ou une ramification comportant une molécule aromatiques et n est un nombre entier supérieur ou égal à 2.

L'obtention du tronc linéaire 1 est parfaitement connue de l'homme du métier.

Notamment, les copolymères ethylène-alpha oléfines sont obtenus classiquement par des procédés connus de l'homme du métier, tels que par exemple par polymérisation Ziegler-Natta, métallocène ou organométallique.

Selon les types et ratio de monomères, le tronc polyoléfine peut être semi-cristallin ou amorphe. Dans le cas des polyoléfines amorphes, seule la température de transition vitreuse est observée, tandis que dans celui des polyoléfines semi-cristallins une température de transition vitreuse et une température de fusion (qui sera nécessairement supérieure) sont observées. Il suffira à l'homme du métier de sélectionner les ratios de monomère et les masses moléculaires du tronc polyoléfine pour pouvoir obtenir aisément les valeurs voulues de température de transition vitreuse, éventuellement de température de fusion ainsi que de viscosité du tronc polyoléfine.

S'agissant des greffons 2 destinés à venir se greffer sur le tronc linéaire 1, il s'agit de polymères conjugués. On entend par l'expression « polymères conjugués » des polymères conjugués possédant une structure électronique caractéristique dite « structure de bande ». Ces polymères sont marqués par la présence sur le squelette d'une alternance entre double et simple liaisons.

Comme cela est connu de l'homme du métier, doper un polymère conjugué consiste généralement à donner (réduire) ou à extraire (oxyder) de celui-ci des électrons. Ce mécanisme entraîne la modification de la structure de la molécule (la géométrie) et par là même la modification de ses propriétés électroniques, à savoir sa conductivité.

A titre d'exemple non limitatif de polymères conjugués, on peut citer le polyacétylène, le polypyrrole, le polythiophène, le polyphénylène et le polyaniline mais de manière plus générale, les polymères conjugués regroupent trois familles principales :

- les poly(p-phénylène vinylène) (PPV), par exemple le poly[2-méthoxy-5-(2'-éthyl-hexyloxy)-1,4-phénylène vinylène] (MEH-PPV)ou le poly[2-méthoxy-5-(3',7'-diméthyloctyloxy)-1-4phénylène vinylène] (MDMO-PPV) ;

- les polythiophènes (PT) résultant de la polymérisation des thiophènes et qui sont des hétérocycles de soufre, par exemple le poly(3-héxylthiophène) (P3HT)

- les polyfluorènes, par exemple le poly[2,7-(9,9-dioctyl-fluorène)-alt-5,5-(48, 78-di-2thiényl-28, 18,38-benzothiadiazole)] (PFDTBT).

Parmi tous les polymères conjugués qui peuvent être choisis pour entrer dans la composition selon la présente invention, la demanderesse a une préférence pour le poly(3-héxylthiophène) (P3HT).

Les greffons 2 sont fixés sur le tronc linéaire 1 par des techniques classiques connues de l'homme du métier. Dans cette perspective, on citera la technique de l'addition sur le tronc linéaire 1, par réaction chimique classique entre les extrémités des greffons 2 et une fonction réactive sur ledit tronc linéaire 1 mais on pourra également se reporter au document WO 1995/029199.

Parmi l'ensemble des copolymères greffés répondant à la définition selon la présente invention, la demanderesse a identifié trois composantes préférées, à savoir :

- un polyisoprène greffé poly(3-héxylthiophène) ;
- un acrylate (de préférence le polyacrylate de butyle) greffé poly(3-héxylthiophène) ;
- un poly(alcool vinylique) greffé poly(3-héxylthiophène).

Outre les techniques d'obtention connues de l'homme du métier pour obtenir ces trois copolymères greffés, la demanderesse a mis au point des procédés originaux susceptibles de présenter un intérêt particulier, notamment du point de vue de la pureté du produit obtenu et d'un moindre coût d'obtention.

Synthèse du polyisoprène greffé P3HT :

Tout d'abord, il convient de synthétiser du Poly(3-hexylthiophène) terminé ω-thiol :

Dans un bicol équipé d'une sortie diazote/vide et surmonté par une burette de toluène dégazé/distillé, il faut introduire 140 mg (milligrammes) de P3HT terminé ω-allyle de masse $M_n$ = 1700 $g.mol^{-1}$ (gramme par mole) (0,08 mmol). Il faut ensuite faire trois cycles de vide/diazote puis ajouter 5 mL de toluène. Il faut laisser agiter 2 heures à 45°C (Celsius) afin de bien solubiliser. Puis, on fait revenir à température ambiante puis ajouter 1 g (gramme) (0,9 mL) de 1,3-propanedithiol (0,92 mmol). On doit alors laisser agiter 5 minutes. Puis, il faut introduire 3 mg d'azobisisobutyronitrile (AIBN) recristallisé (0,02 mmol) et placer le milieu réactionnel à 80°C. Après 3h30 de réaction, il faut ajouter de nouveau 3 mg d'AIBN. Il faut laisser alors agiter 16 heures à 80°C. En fin de réaction, précipiter dans le méthanol froid (50 mL). Filtrer et sécher le produit sous vide à température ambiante pendant 24 heures.

La synthèse du copolymère greffé PI-g-P3HT s'opère comme suit :

Dans un bicol équipé d'une sortie diazote/vide et surmonté par une burette de toluène dégazé/distillé, introduire 120 mg de P3HT terminé ω-thiol de masse $M_n$ = 1700 $g.mol^{-1}$ (0,07 mmol). Il faut faire trois cycles de vide/diazote puis ajouter 8 mL de toluène. Ensuite, il faut laisser agiter 1 heure à 60°C afin de bien solubiliser. Revenir à température ambiante puis ajouter 40 mg de Poly(isoprène) de masse $M_n$ = 2650 $g.mol^{-1}$ (0,015 mmol, 16% d'unité 1,2 et 67% d'unité 3,4). Il faut laisser agiter 1 heure puis introduire ensuite 3 mg d'AIBN recristallisé (0,02 mmol) et placer le milieu réactionnel à 80°C. Après 3h30 (trois heures et 30 minutes) de réaction, ajouter de nouveau 3 mg d'AIBN. Il faut laisser alors agiter 16 heures à 80°C. En fin de réaction, précipiter dans le méthanol froid (80 mL). Enfin, il faut filtrer et sécher le produit sous vide à température ambiante pendant 24 heures.

Synthèse d'un acrylate greffé P3HT :

La synthèse du Poly(3-hexylthiophène) terminé ω-acrylate s'opère comme suit :

Dans un bicol avec une sortie diazote/vide, préalablement séché au décapeur thermique sous vide et surmonté d'une burette de tetrahydrofurane (THF) fraîchement distillé, il faut introduire 280 mg de P3HT terminé ω-hydroxyle de masse $M_n$ = 2000 $g.mol^{-1}$ (0,14 mmol) sous flux de diazote. Il faut ensuite faire trois cycles de vide/diazote puis laisser le ballon sous vide et ajouter 50 mL de THF. Enfin, il faut laisser agiter pendant au moins 30 min à 40°C afin de bien solubiliser le polymère. A la suite de cette étape, il faut revenir à température ambiante puis ajouter sous flux de diazote à l'aide d'une seringue purgée, 2,2 mL de triéthylamine (15,5 mmol). Ensuite, il est nécessaire de laisser agiter pendant 15 minutes pour refroidir alors le milieu réactionnel à 0°C. Enfin, il faut ajouter alors le chlorure d'acryloyle goutte-à-goutte via une seringue purgée. Puis, il est nécessaire de laisser agiter pendant 24 heures en laissant revenir le milieu réactionnel à température ambiante. En fin de réaction, précipiter le polymère dans le méthanol froid (500 mL). Afin, comme dernière étape, il est nécessaire de filtrer puis sécher le produit sous vide pendant 48 heures à température ambiante.

Ensuite, la synthèse du copolymère greffé PBA-g-P3HT s'opère comme suit :

Dans un tube Schlenk, équipé d'une sortie diazote/vide, introduire 100 mg de P3HT terminé ω-acrylate de masse $M_n$ = 2000 g.mol$^{-1}$ (0,05 mmol) ainsi que 4 mg de dérivés d'alkoxyamine (0.01 mmol) (Blocbuilder® de la société Arkema). Il faut ensuite faire trois cycles de vide/diazote afin d'éliminer toutes traces de dioxygène pour introduire ensuite 0,5 mL de toluène dégazé. Ensuite, il faut laisser agiter 30 minutes à 45°C pour bien solubiliser. Ensuite, il est nécessaire de revenir à température ambiante puis ajouter 0,05 mL d'acrylate de *n*-butyle (0,35 mmol), préalablement distillé et dégazé. Il faut laisser agiter cinq minutes à température ambiante. La polymérisation est démarrée en plongeant directement le Schlenk dans un bain d'huile à 115°C. Il est souhaitable de laisser agiter cinq heures puis introduire à nouveau 0,05 mL d'acrylate de *n*-butyle pour ajouter à nouveau au bout de seize heures la même quantité. Il est nécessaire de laisser agiter vingt quatre heures. En fin de réaction, l'opérateur plonge le Schlenk dans de l'azote liquide afin de stopper la polymérisation et précipiter dans le méthanol froid (5 mL), filtrer et sécher sous vide à 50°C pendant vingt quatre heures. Les macromonomères restant sont séparés par chromatographie flash (gel de silice, dichlorométhane). Le copolymère est récupéré ensuite grâce à un mélange dichlorométhane/acétate d'éthyle (85/15). Il faut précipiter le produit dans du méthanol froid, filtrer et sécher sous vide à 50°C pendant 24 heures.

Synthèse d'un poly(alcool) de vinyle greffé P3HT :

La synthèse du Poly(3-hexylthiophène) terminé ω-acide carboxylique est réalisée comme suit :

Dans un bicol équipé d'une sortie diazote/vide et surmonté par une burette de toluène dégazé/distillé, il faut introduire 140 mg de P3HT terminé ω-allyle de masse $M_n$ = 1700 g.mol$^{-1}$ (0,08 mmol). Il faut ensuite faire trois cycles de vide/diazote puis ajouter sous flux de diazote, 5 mL de toluène. Il faut laisser agiter deux heures à 45°C afin de bien solubiliser. Il est nécessaire de revenir à température ambiante puis ajouter 1 g (0,8 mL) d'acide mercaptopropionique (0,94 mmol). De préférence, il est ensuite souhaitable de laisser agiter cinq minutes. Il est nécessaire d'introduire ensuite 3 mg d'AIBN recristallisé (0,02 mmol) et placer le milieu réactionnel à 80°C. Après 3h30 de réaction, il faut ajouter de nouveau 3 mg d'AIBN. Il est souhaitable de laisser alors agiter 16 heures à 80°C. En fin de réaction, on précipite le mélange dans le méthanol froid (50 mL). Enfin, on filtre et on séche le produit sous vide à température ambiante pendant 24h.

La synthèse du copolymère greffé PVA-g-P3HT s'opère comme suit :

Dans un monocol équipé d'une sortie diazote/vide et séché au décapeur thermique sous vide, on introduit 100 mg de poly(acétate de vinyle) (PVA) commercial de masse moyenne $M_n$ = 18000 g.mol$^{-1}$ (0,01 mmol) et faire trois cycles de vide/diazote. Il faut ensuite ajouter 9 mL de diméthylsulfoxyde distillé sous flux de diazote à l'aide d'une seringue purgée et chauffer à 60°C pour bien solubiliser le polymère. Il est ensuite souhaitable de laisser agiter 2 heures à 60°C puis revenir à température ambiante. Dans un tube Schlenk équipé d'une sortie diazote/vide et séché au décapeur thermique sous vide, on introduit 90 mg de P3HT terminé ω-acide carboxylique de masse $M_n$ = 1700 g.mol$^{-1}$ (0,05 mmol). On réalise trois cycles de vide/diazote puis ajouter 3 mL de dichlorométhane distillé. Puis, on laisse agiter deux heures à température ambiante. Ensuite, il faut ajouter ensuite cette deuxième solution à la première au goutte-à-goutte à l'aide d'une seringue purgée et laisser agiter le milieu réactionnel 30 min à 40°C. Il faut introduire alors 8 mg de 4-(diméthylamino)pyridinium-4-toluenesulfonate (0,03 mmol) et laisser agiter 30 min, toujours à 40°C. Enfin, il faut ajouter 85 mg de N,N'diisopropylcarbodiimide (0,07 mmol) et laisser agiter 72 heures à 40°C. En fin de réaction, il faut précipiter le copolymère PVA-g-P3HT dans le dichlorométhane (100 mL), filtrer et sécher sous vide pendant 24h à 60°C.

On notera enfin que la composition selon l'invention incorpore avantageusement, en particulier dans l'application aux cellules photovoltaïques organiques, des petites molécules se caractérisant par leur faible masse moléculaire qui ne dépasse pas quelques milliers d'unités de masse atomique. A l'instar des polymères conjugués, ces petites molécules sont des accepteurs ou des donneurs d'électrons, ce qui permet que ces derniers facilitent également le transport des charges électriques et sont susceptibles de former avec les polymères conjugués des excitons.
Ces petites molécules sont généralement ajoutées à la composition par dissolution dans le mélange contenant les autres composants (polymères).
On citera à ce titre :

- le fullerène $C_{60}$ qui est un composé formé de 60 atomes de carbones et dont la forme sphérique est proche de celle d'un ballon de football. Cette molécule est ici préférée comme ajout dans la composition selon l'invention même s'il

a été précisé précédemment que le terme fullerène désigne une molécule composée exclusivement de carbones pouvant prendre une forme géométrique rappelant celle d'une sphère, d'un ellipsoïde, d'un tube (appelé nanotube) ou d'un anneau ;

- le [6,6]-phényl-$C_{61}$-butanoate de méthyle (PCBM) qui est un dérivé du fullerène dont la structure chimique a été modifié pour le rendre soluble ;

- les nanotubes de carbones et les graphènes ;

- le pérylène consistant en un noyau aromatique d'hydrocarbures de formule chimique C20H12, par exemple le N, N'-diméthyl-3,4,9,10 perylenete-tracarboxylique-diimide (PTCDI) (dérivé du pérylène avec deux atomes d'azotes, deux atomes d'oxygènes et deux groupes méthyles CH3) ou le pérylène-3,4,9,10-tetracarboxylique-dianhydride (PTCDA) (dérivé du pérylène avec six atomes d'oxygène).

Dans l'application particulière de la composition aux modules photovoltaïques, le rayonnement UV étant susceptible d'entraîner un léger jaunissement de la composition utilisée, des stabilisants UV et des absorbeurs UV tels que le benzotriazole, le benzophénone et les autres amines encombrés, peuvent être ajoutés afin d'assurer la transparence de l'encapsulant durant sa durée de vie. Ces composés peuvent être par exemple à base de benzophénone ou de benzotriazole. On peut les ajouter dans des quantités inférieures à 10% en masse de la masse totale de la composition et préférentiellement de 0,1 à 5%.

On pourra également ajouter des anti-oxydants pour limiter le jaunissement lors de la fabrication de l'encapsulant tels que les composés phosphorés (phosphonites et/ou phosphites) et les phénoliques encombrés. On peut ajouter ces anti-oxydants dans des quantités inférieures à 10% en masse de la masse totale de la composition et préférentiellement de 0,1 à 5%.

Des agents retardateurs de flamme peuvent également être ajoutés. Ces agents peuvent être halogénés ou non-halogénés. Parmi les agents halogénés, on peut citer les produits bromés. On peut également utiliser comme agent non-halogéné les additifs à base de phosphore tels que le phosphate d'ammonium, de polyphosphate, de phosphinate ou de pyrophosphate, le cyanurate de mélamine, le pentaérythritol, les zéolithes ainsi que les mélanges de ces agents. La composition peut comprendre ces agents dans des proportions allant de 3 à 40% par rapport à la masse totale de la composition.

Si cela est souhaité dans une application particulière, on peut également ajouter des pigments comme par exemple des composés colorants ou azurants dans des proportions allant généralement de 5 à 15% par rapport à la masse totale de la composition.

Concernant les autres aspects de l'invention relatifs à l'utilisation de la composition selon l'invention dans un module photovoltaïque, l'Homme de l'Art peut se référer par exemple au Handbook of Photovoltaic Science and Engineering, Wiley, 2003 volume 7.

On notera à nouveau que la composition selon la présente invention peut également être utilisée dans d'autres domaines que celui du photovoltaïque. En particulier, la composition selon l'invention pour être utilisée dans des électrodes transparentes pour des cellules photovoltaïques ou des diodes électroluminescentes organiques (OLED).

L'homme du métier pourra également envisager d'utiliser la composition selon l'invention dans les encres de semi-conducteurs pour les dispositifs électroniques d'impression.

On notera que la composition selon l'invention peut être utilisée pour la dispersion de nanotubes de carbone, cette dispersion étant utilisable pour la fabrication d'électrodes ou d'autres composants rentrant dans la fabrication de dispositifs optoélectroniques comme les cellules photovoltaïques ou les OLEDs.

**Matériaux employés pour former les formulations testées** :

Dans la suite il est présenté des tests sur des compositions selon l'invention démontrant la satisfaction de ces compositions au regard des deux premiers problèmes techniques exposés précédemment, à savoir essentiellement :

1. le problème de compatibilisation d'un mélange entre un matériau donneur et un matériau accepteur d'électrons dans une cellule organique,

2. accroître les qualités de surfactant afin d'améliorer la qualité et la stabilité d'encres.

Il doit être noté que concernant le problème physico-chimique d'interface métal/matériau organique. Il a été

constaté par la demanderesse au travers d'un grand nombre d'expériences que les compositions selon l'invention permettent l'amélioration et la stabilisation des interfaces organique/inorganique dans un dispositif organique avec au moins une électrode métallique. Des résultats pourront être présentés ultérieurement par la demanderesse.

Les copolymères de type polyoléfine greffée P3HT (PI-g-P3HT), polyacrylate greffé P3HT (PBuA-g-P3HT) et poly(alcool vinylique) (PVA-g-P3HT) ont été testés comme compatibilisant d'une couche active de cellule photovoltaïque organique composée d'un mélange d'un polymère conjugué, le P3HT, et d'un fullerène, le PCBM.

**1) Utilisation des copolymères greffés comme compatibilisant de la couche active (problème 1 susvisé) :**

**Obtention des formulations et films testés:**

Dans ce cas, les cellules testées ont été élaborées sous atmosphère contrôlée (absence d'oxygène et d'humidité, tels que mesurés à des teneurs < 10 ppm) à partir d'une formulation comprenant un des copolymères geffés, du P3HT et du PCBM. La formulation est réalisée de la façon suivante :

Différentes quantités de compatibilisant (0 à 10% massique par rapport à la quantité P3HT/PCBM) sont introduites dans une solution de P3HT/PCBM (mélange 1/1, concentration globale de 40 $mg.mL^{-1}$) dans de l'ortho-dichlorobenzene. Les solutions ainsi préparées sont alors laissées sous agitation pendant 16 heures à 50°C (degrés Celsius) afin d'avoir une dissolution complète. Par ailleurs, les substrats ITO (oxyde d'indium $In_2O_3$ dopé à l'étain) sur verre sont lavés dans un bain à ultrason. Ceci est réalisé dans un premier temps dans de l'acétone, puis dans l'éthanol et enfin dans de l'isopropanol. Chaque lavage dure quinze minutes. Après avoir séché et traité le substrat par UV-ozone durant quinze minutes une couche mince de PEDOT-PSS (poly(3,4-éthylènedioxythiophène) = PEDOT et le poly(styrène sulfonate) de sodium = PSS) a été déposée par la technique du « spin-coating » bien connue de l'homme du métier à une vitesse de cinq milles tours par minute (5000 Tr / min.) et ensuite séchée dans une étuve à 110°C sous vide dynamique. L'épaisseur de la couche de PEDOT-PSS est de 50 nm (nanomètre). Elle a été mesurée à l'aide d'un appareil Alpha-step IQ Surafe Profiler. Par la suite, la couche active, mélange P3HT/PCBM avec différentes quantités de compatibilisant (filtré à l'aide d'une membrane PTFE, avec des pores de 0.2 $\mu$m de diamètre) a été déposée par « spin-coating » au-dessus de la couche PEDOT-PSS sous atmosphère inerte. L'épaisseur de la couche active est comprise entre 80 et 100 nm. La cathode (aluminium) a été déposée thermiquement à travers un « shadow mask » avec une pression de $10^{-7}$ mbar (millibar). La surface active du dispositif est de 8,4 $mm^2$ (millimètre carré). Une configuration standard a été employée pour la fabrication du dispositif: verre/ITO/PEDOT-PSS/couche active/aluminium. Après avoir déposé la cathode, un recuit thermique est réalisé sur une plaque chauffante à 165°C pendant vingt minutes. On refroidit ensuite les dispositifs jusqu'à température ambiante avant toutes caractérisations. Toutes les procédures effectuées après la déposition de la couche PEDOT-PSS ont été réalisées dans une boîte à gants sous atmosphère inerte (diazote) avec une quantité de poussières et de dioxygène inférieure à 0.1 ppm (partie par million).

**Tests réalisés sur les films:**

Les mesures de courant-tension du dispositif ont été réalisées avec un appareil Keithley 4200 SCS dans le noir et sous illumination de 100 $mW.cm^{-2}$ (milliwatt par centimètre carré) à partir d'un appareil « K.H.S. SOlarCellTest575 simulator » avec des filtres AM1,5G. Les contacts ont été faits en utilisant une sonde de type « Karl Suss PM5 ». Il y a quatre diodes par échantillon. Afin de vérifier la répétitivité des performances, les mesures ont été réalisées sur 8 diodes solaires différentes.

L'effet photovoltaïque d'une cellule solaire est caractérisé par les paramètres suivant : la tension de circuit ouvert ($V_{CO}$), le courant court-circuit ($J_{CC}$) et le facteur de remplissage (FF). Le rendement de la conversion énergétique (PCE) est le rapport entre la puissance générée et la puissance de la lumière incidente ($P_{in}$) :

$$PCE = (V_{co} * J_{cc} * FF) / P_{in}$$

**Résultats des tests réalisés** :

Le PCE a été mesuré plusieurs fois pour chaque composition, avant le recuit à 165°C et après le recuit. Selon la série le PCE obtenu après recuit pour la cellule de référence (sans ajout de copolymère) est autour de 4,5%, ce qui correspond donc aux tests selon l'art antérieur.

Dans le tableau suivant est indiqué l'effet relatif de l'ajout du copolymère sur le PCE (en pourcentage d'amélioration) avant et après recuit, avec des compositions selon l'invention. Les résultats présentés avec les compositions

selon l'invention montrent une augmentation significative des performances qui sont considérées par rapport à la cellule de référence de l'art antérieur.

| Additif | Modification du PCE avant recuit | Modification du PCE après recuit |
|---|---|---|
| PI-g-P3HT | De +30% à +60 % | De +10% à +40 % |
| PBuA-g-P3HT | De +20% à +50 % | De +5% à +20 % |
| PVA-g-P3HT | De +0 % à +5% | De -5% à +0% |

L'amélioration après recuit montre un réel effet des additifs sur la morphologie et les performances. L'amélioration encore plus importante avant recuit montre un effet positif sur la processabilité de la couche active (obtention plus rapide de la morphologie optimale) et donc la possibilité de diminuer les temps et/ou les températures de recuit, et donc le coût de production.

**2) Amélioration de la qualité des encres - leurs stabilités - à base de dispersion de nanotubes de carbone (problème 2 susvisé) :**

**Obtention des formulations et films testés** :

Les encres (dispersions) étudiées ont été élaborées à partir nanotubes de Carbone multi-parois ou multi-feuillet (MWCNT, Arkéma®) dispersé dans de l'eau sans aucun ajout de tensioactif ionique.
La formulation de référence comporte 0,1% (en poids par rapport au total) de MWCNT. Le volume total d'eau utilisé est de 5 ml pour chacune des formulations.
A cette formulation de référence (= état de l'art) a été ajouté 0.5% (en poids par rapport au total) d'un additif : soit un copolymère greffé de type PVA-g-P3HT soit un poly(alcool de vinyle) (PVA) de masse molaire équivalente (= état de l'art).

**Tests réalisés sur les films** :

Toutes les formulations sont passées au sonificateur pendant vingt minutes.
Les dispersions sont observées d'abord à l'oeil nu puis au microscope optique sur une lame de verre et enfin au microscope à force atomique (AFM) après sur verre dépôt et séchage.

**Résultats des tests réalisés :**

| Formulation de référence (Etat de la technique | Formulation avec du PVA (ET) | Formulation avec le PVA-g-P3HT (composition selon l'invention) |
|---|---|---|
| Décantation (2 phases) | Décantation (2 phases) | Dispersion des nanotubes dans l'eau |

Dans le cas de la formulation selon l'invention, les dispersions sont très fines, la taille des particules les plus grosses observées en microscopie est de l'ordre du micron. A partir de ces dispersions, des films homogènes ont été réalisés, résultats confirmés en AFM (Microscopie à Force Atomique) visible sur la figure 2.
Après un vieillissement de sept jours, les dispersions n'ont pas évoluées et sont toujours aussi stables.
Ces résultats montrent que, grâce à l'invention, il est possible d'obtenir des encres de MWNTC stables utilisables pour former facilement des couches de ce matériau (électrodes notamment) durant le procédé de d'élaboration de la cellule photovoltaïque ainsi que dans d'autres types de dispositifs (OLED par exemples).

## Revendications

**1.** Composition comprenant un copolymère greffé constitué:

- d'un tronc linéaire (1) comprenant au moins un polymère vinylique non aromatique ou une polyoléfine insaturée,

et

- au moins deux greffons (2), rattaché audit tronc par une liaison chimique, chacun constitué d'un polymère conjugué,

**caractérisée en ce que** ladite composition comprend en outre:

- des fullerènes et un polymère conjugué, ou
- des nanotubes de carbone et/ou du graphène.

**2.** Composition selon la revendication 1, **caractérisée en ce que** les deux greffons (2) ont la même masse molaire.

**3.** Composition selon la revendication 1 ou 2, **caractérisée en ce que** les susdits greffons (2) consistent en du poly-(3-hexylthiophène).

**4.** Composition selon l'une quelconque des revendications précédentes, **caractérisée en ce que** le tronc linéaire (1), de nature polyoléfine insaturée, consiste en un polydiène, de préférence un polyisoprène ou un polybutadiène, de façon préférentielle un polyisoprène.

**5.** Composition selon les revendications 1 à 3, **caractérisée en ce que** le tronc linéaire (1) consiste en un polymère acrylique ou polyacrylate.

**6.** Composition selon la revendication précédente, **caractérisée en ce que** ledit tronc est un polyacrylate d'alkyle, de préférence du poly(acrylate de n-butyle).

**7.** Composition selon les revendications 1 à 3, **caractérisée en ce que** le tronc possède des fonctions hydroxyles de sorte à lui conférer des propriétés amphiphiles.

**8.** Composition selon l'une des revendications 1 à 3 et 6, **caractérisée en ce que** le tronc linéaire (1), de nature polyoléfine insaturée, consiste en du poly(alcool vinylique).

**9.** Utilisation de la composition selon l'une quelconque des revendications précédentes, lorsqu'elle comporte des fullerènes et un polymère conjugué, dans les cellules photovoltaïques organiques d'un module photovoltaïque.

**10.** Module photovoltaïque présentant au moins une couche formant encapsulant comportant une pile photovoltaïque, consistant en une pluralité de cellules photovoltaïques organiques, apte a générer de l'énergie électrique, et une couche formant un « backsheet » ou panneau arrière, ladite pile photovoltaïque comprenant une composition selon l'une quelconque des revendications 1 à 8 lorsqu'elle comporte des fullerènes et un polymère conjugué.

**11.** Utilisation de la composition selon l'une quelconque des revendications 1 à 8, lorsqu'elle comporte des nanotubes de carbone et/ou du graphène, dans des électrodes.

## Patentansprüche

**1.** Zusammensetzung, umfassend ein gepfropftes Copolymer, das aus Folgendem besteht:

- einem geraden Hauptstamm (1), der mindestens ein nicht-aromatisches Vinylpolymer oder ein ungesättigtes Polyolefin umfasst, und
- mindestens zwei Pfropfungen (2), die an den Hauptstamm durch eine chemische Bindung gebunden sind und jeweils aus einem konjugierten Polymer bestehen, **dadurch gekennzeichnet, dass** die Zusammensetzung außerdem Folgendes umfasst:

  - Fullerene und ein konjugiertes Polymer oder
  - Kohlenstoff-Nanoröhren und/oder Graphen.

**2.** Zusammensetzung nach Anspruch 1, **dadurch gekennzeichnet, dass** die beiden Pfropfungen (2) die gleiche Molmasse besitzen.

3. Zusammensetzung nach Anspruch 1 oder 2, **dadurch gekennzeichnet, dass** die Pfropfungen (2) aus Poly-(3-hexylthiophen) bestehen.

4. Zusammensetzung nach einem der vorhergehenden Ansprüche, **dadurch gekennzeichnet, dass** der gerade Hauptstamm (1) des Typs eines ungesättigten Polyolefins aus einem Polydien, vorzugsweise einem Polyisopren oder einem Polybutadien, bevorzugt einem Polyisopren besteht.

5. Zusammensetzung nach den Ansprüchen 1 bis 3, **dadurch gekennzeichnet, dass** der gerade Hauptstamm (1) aus einem Acrylpolymer oder Polyacrylat besteht.

6. Zusammensetzung nach dem vorhergehenden Anspruch, **dadurch gekennzeichnet, dass** der Hauptstamm ein Polyalkylacrylat, vorzugsweise Poly(n-butylacrylat) ist.

7. Zusammensetzung nach den Ansprüchen 1 bis 3, **dadurch gekennzeichnet, dass** der Hauptstamm Hydroxylfunktionen besitzt, so dass ihm amphiphile Eigenschaften verliehen werden.

8. Zusammensetzung nach einem der Ansprüche 1 bis 3 und 6, **dadurch gekennzeichnet, dass** der gerade Hauptstamm (1) des Typs eines ungesättigten Polyolefins aus Poly(vinylalkohol) besteht.

9. Verwendung der Zusammensetzung nach einem der vorhergehenden Ansprüche, wenn sie Fullerene und ein konjugiertes Polymer enthält, in den organischen Photovoltaikzellen eines Photovoltaikmoduls.

10. Photovoltaikmodul, das mindestens eine eine Einkapselung bildende Schicht, die einen Photovoltaikstapel, bestehend aus einer Mehrzahl an organischen Photovoltaikzellen, die elektrische Energie erzeugen können, enthält, und eine eine "Backsheet" oder Rückseite bildende Schicht aufweist, wobei der Photovoltaikstapel eine Zusammensetzung nach einem der Ansprüche 1 bis 8, wenn sie Fullerene und ein konjugiertes Polymer enthält, umfasst.

11. Verwendung der Zusammensetzung nach einem der Ansprüche 1 bis 8, wenn sie Kohlenstoff-Nanoröhren und/oder Graphen umfasst, in Elektroden.

## Claims

1. Composition comprising a grafted copolymer consisting:

   - of a linear trunk (1) comprising at least one nonaromatic vinyl polymer or one unsaturated polyolefin, and
   - at least two grafts (2), attached to said trunk via a chemical bond, each consisting of a conjugated polymer,

   **characterized in that** said composition additionally comprises:

     - fullerenes and a conjugated polymer, or
     - carbon nanotubes and/or graphene.

2. Composition according to Claim 1, **characterized in that** the two grafts (2) have the same molar mass.

3. Composition according to Claim 1 or 2, **characterized in that** the abovesaid grafts (2) consist of poly(3-hexylthiophene).

4. Composition according to any one of the preceding claims, **characterized in that** the linear trunk (1), of unsaturated polyolefin nature, consists of a polydiene, preferably a polyisoprene or a polybutadiene, preferentially a polyisoprene.

5. Composition according to Claims 1 to 3, **characterized in that** the linear trunk (1) consists of an acrylic polymer or polyacrylate.

6. Composition according to the preceding claim, **characterized in that** said trunk is a polyalkyl acrylate, preferably poly(n-butyl acrylate).

7. Composition according to Claims 1 to 3, **characterized in that** the trunk has hydroxyl functional groups so as to confer amphiphilic properties on it.

8. Composition according to one of Claims 1 to 3 and 6, **characterized in that** the linear trunk (1), of unsaturated polyolefin nature, consists of poly(vinyl alcohol).

9. Use of the composition according to any one of the preceding claims, when it comprises fullerenes and a conjugated polymer, in the organic photovoltaic cells of a photovoltaic module.

10. Photovoltaic module exhibiting at least one layer forming an encapsulant comprising a photovoltaic cell, consisting of a plurality of organic photovoltaic cells capable of generating electrical energy, and a layer forming a back sheet, said photovoltaic cell comprising a composition according to any one of Claims 1 to 8 when it comprises fullerenes and a conjugated polymer.

11. Use of the composition according to any one of Claims 1 to 8, when it comprises carbon nanotubes and/or graphene, in electrodes.

Figure 1

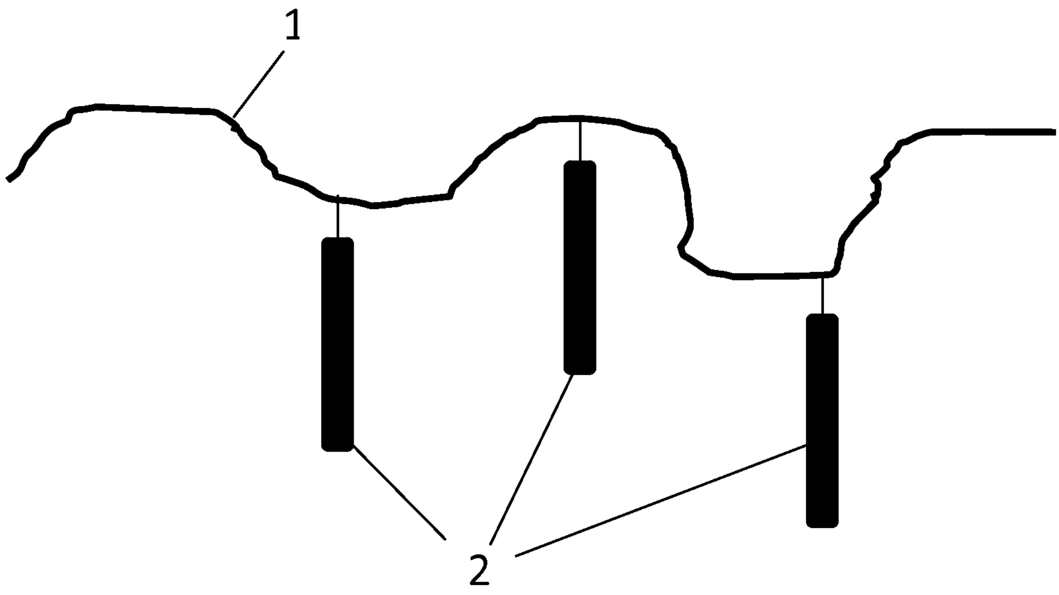


Figure 2

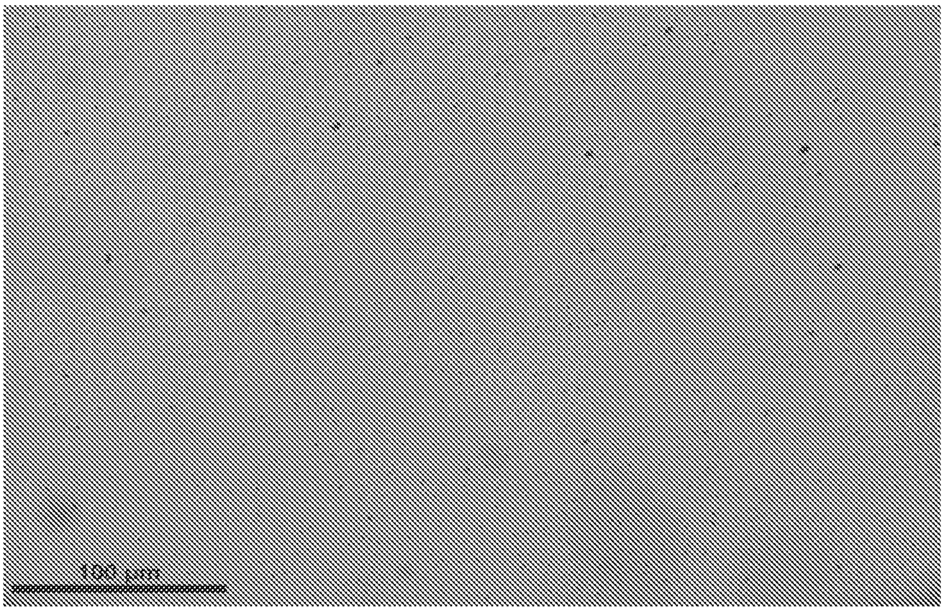

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- US 20090229667 A
- US 20080017244 A
- WO 2006096550 A
- WO 1995029199 A


### Littérature non-brevet citée dans la description


- **ERTUGRUL SAHMETLIOGLU et al.** *Polymer International,* 01 Janvier 2004
- **GREGORY L. BAKER et al.** Synthesis of polyacetylene block/graft copolymers. *Macromolecules,* 01 Décembre 1984
- Handbook of Photovoltaic Science and Engineering. Wiley, 2003, vol. 7